## Europäisches Patentamt

## European Patent Office

## Office européen des brevets

(19)

(11) Veröffentlichungsnummer: **0 161 627**
**B1**

(12) # EUROPÄISCHE PATENTSCHRIFT

(45) Veröffentlichungstag der Patentschrift:
29.11.89

(51) Int. Cl.⁴: **H 03 F 3/45, H 03 F 1/48**

(21) Anmeldenummer: **85105600.2**

(22) Anmeldetag: **07.05.85**

(54) **Bipolare Verstärkerschaltung.**

(30) Priorität: **16.05.84 DE 3418214**

(43) Veröffentlichungstag der Anmeldung:
**21.11.85 Patentblatt 85/47**

(45) Bekanntmachung des Hinweises auf die Patenterteilung:
**29.11.89 Patentblatt 89/48**

(84) Benannte Vertragsstaaten:
**AT DE FR GB IT NL**

(56) Entgegenhaltungen:
**EP-A- 0 095 824**

**PROCEEDINGS OF THE IEEE, Band 65, Nr. 12,
Dezember 1977, Seiten 1721-1723, New York, US; S.
POOKAIYAUDOM u.a.: "High-performance differential
quartets"**
**IEEE JOURNAL OF SOLID-STATE CIRCUITS, Band
SC-16, Nr. 6, Dezember 1981, Seiten 626-633, IEEE, New
York, US; R.A. BLAUSCHILD: "An open loop
programmable amplifier with extended frequency
range"**
**IDEM**

(73) Patentinhaber: **Siemens Aktiengesellschaft,
Wittelsbacherplatz 2, D-8000 München 2 (DE)**

(72) Erfinder: **Wilhelm, Wilhelm, Dr.-Ing.,
Geigenbergerstrasse 23, D-8000 München (DE)**
Erfinder: **Sehrig, Peter, Ing.-grad., Berchemstrasse 41,
D-8000 München 21 (DE)**

**Beschreibung**

Die Erfindung betrifft eine bipolare Verstärkerschaltung nach dem Oberbegriff des Patentanspruches 1.

Gattungsgemäße Halbleiterschaltungen sind aus der EP-A2 0 095 824 und dem Artikel von Robert A. Blauschild, «An Open Loop Programmable Amplifier with Extended Frequency Range», IEEE Journal Of Solid-State Circuits, Vol. SC-16, No. 6, December 1981, Seiten 626 bis 633 bekannt und werden zur Erhöhung der Verstärkung eingesetzt.

Bipolare Verstärker oder Komparatoren vergleichen zwei Eingangssignale und besitzen, abhängig von der Entscheidung, entweder einen hohen oder niedrigen Ausgangspegel. Entscheidungskriterium ist oft, ob die Differenz der Eingangssignale positiv oder negativ ist. Wünschenswert ist ein kleiner erforderlicher Signalhub, um die Verlustleistung, die in einer digitalen Schaltung im wesentlichen durch den Signalhub und den vorgegebenen Lastwiderstand bestimmt ist, gering zu halten. Andererseits verlangt eine regenerationsfähige Schaltung, deren Ausgangsamplituden einen bestimmten Pegel besitzen und im (hochfrequenten) Taktraster liegen, gewisse minimale Signalhübe und eine entsprechend hohe Bandbreite.

Nach dem Stand der Technik benötigen Komparator- oder Operationsverstärkerschaltungen mit hoher Empfindlichkeit, um eine genügend hohe Verstärkung zu erzielen, eine Reihe von Bauelementen, sind häufig mehrstufig aufgebaut oder besitzen Sromquellen im Lastkreis. Diese Schaltungsmaßnahmen schränken allerdings die Bandbreite ein.

Herkömmliche Komparatorschaltungen in Stromschalter-Technik, auch als Current Mode Logic (CML) bezeichnet, mit der sich kurze Schaltzeiten erreichen lassen, weil die Transistoren nicht in die Sättigung gelangen können, erfordern beim Stand der Technik etwa 500 mV Signalhub. Gegentaktschaltungen arbeiten noch mit etwa 200 mV Signalhub, allerdings beträgt der Strom bei einem 50 Ohm-Lastwiderstand immer noch 4 mA.

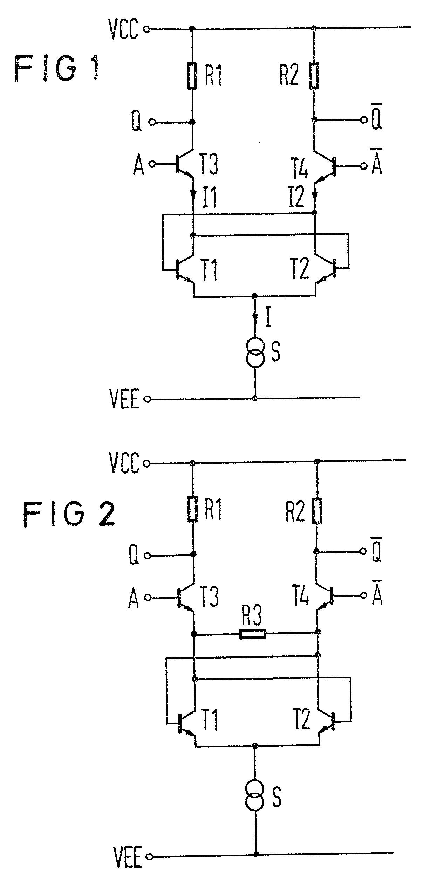

Die Funktionsweise einer gattungsgemäßen Schaltung wird nachstehend anhand der Fig. 1 dargelegt.

Die Schaltung verwendet eine kreuzweise rückgekoppelte Differenzverstärkerstufe mit Diodenstrecken im Lastkreis. Die Emitter der die Differenzverstärkerstufe bildenden Transistoren T1 und T2 sind miteinander und mit dem Ausgang einer Stromquelle S verbunden, deren anderer Anschluß das Potential $V_{EE}$ der Versorgungsspannungsquelle besitzt. Die Stromquelle S liefert den Konstantstrom I von typisch 1 mA und verbessert aufgrund ihres sehr hohen Innenwiderstands die Gleichtaktunterdrückung der Differenzverstärkerstufe.

Der Kollektor von T1 ist auf die Basis von T2 rückgekoppelt und gleichzeitig am Emitter von T3 angeschlossen, während der Kollektor von T2 auf die Basis von T4 rückgekoppelt ist und außerdem mit dem Emitter von T4 verbunden ist. Die Basis von T3 bildet den nichtinvertierenden Eingang A des Verstärkers und am Kollektor, der über dem Widerstand R1 am Pol VCC der Versorgungsspannungsquelle liegt, ist das nichtinvertierte Ausgangssignal Q abzugreifen. Entsprechend liegt an der Basis von T4 das inverse Eingangssignal $\overline{A}$ und an seinem Kollektor das inverse Ausgangssignal $\overline{Q}$ und ein Anschluß des Widerstandes R2, dessen anderer Anschluß mit dem Pol VCC der Versorgungsspannungsquelle verbunden ist.

Mit der Annahme, daß die Differenzspannung $U(A)-U(\overline{A})$ positiver wird, d.h. U(A) ansteigt und $U(\overline{A})$ absinkt, leitet der Transistor T3 besser und der Transistor T4 beginnt zu sperren. Ein höherer Strom durch T3 bewirkt einen höheren Basisstrom von T2, der dann ebenfalls einen höheren Strom zieht und dessen Kollektor-Emitter-Spannung abnimmt. Durch die Rückkopplung des Kollektors von T2 auf die Basis von T1 bei gleichzeitig niedrigerem Strom durch T4 nimmt der Basisstrom von T1 und damit sein Kollektorstrom beschleunigt ab. Über die Rückkopplung des Kollektors von T1 auf die Basis von T2 steigt dessen Basisstrom wiederum verstärkt an. Das Spiel dauert so lange, bis der Strom I1 durch R1, T3 und T1 minimal und der Strom I2 durch R2, T4, T2 maximal wird. «Maximal» bedeutet, daß die Transistoren nicht in die Sättigung gelangen dürfen, aber andererseits der Spannungsabfall I2 R2 ausreicht, um das Signal $\overline{Q}$ zu erzeugen. Im anderen Strompfad muß I1 so klein werden, daß am Ausgang Q hohes Potential liegt. Durch die Mitkopplung von T1 und T2 sind für A bzw. $\overline{A}$ nur minimale Hübe erforderlich.

Mit den Diodenstrecken im Lastkreis der Differenzverstärkerstufe lassen sich die Spannungsabfälle am Differenzverstärker mit Ausnahme der durch die Basisströme verursachten Spannungsabfälle kompensieren. Die Teilkompensation reicht aus, um eine hohe differentielle Stromverstärkung im Übergangsbereich, i.e. der Bereich der Eingangs(differenz)spannung, der zur Änderung des Ausgangssignals um den Signalhub $\Delta I \cdot R$ erforderlich ist, zu erreichen und die Verstärkung um den Faktor $\beta/4$ gegenüber einem Differenzverstärker in Stromschaltertechnik mit Widerstandslast anzuheben, wobei $\beta$ die Kleinsignal-Stromverstärkung der Transistoren ist. Die Übergangsspannung, definiert als Spannungsdifferenz der Schnittpunkte einer Geraden durch den Punkt maximaler Steigung der Funktion $U(Q) = f(U(A) - U(\overline{A}))$ mit den abszissen-parallelen Geraden durch $U(Q)_{max, min}$ (Asymptoten) für sehr große Beträge $U(A) - U(\overline{A})$, beträgt bei der Schaltung nach Fig. 1 nur etwa 2 mV und liegt damit etwa um den Faktor 25 unter dem für eine Gegentakt-Stromschalter-Anordnung geltenden Wert.

Die hohe Empfindlichkeit der Komparatorschaltung nach Fig. 1 geht andererseits zu Lasten der oberen Grenzfrequenz bzw. der Signallaufzeit. Neben der aus dem Lastwiderstand, d.h. den Widerständen R1 und R2 sowie den niedrigen dynamischen Kollektor-Emitter-Widerständen der Steuertransistoren T3 und T4, und den unvermeidlichen parasitären Kapazitäten gegebenen Zeitkonstanten ist dafür vor allem die verlangsamende Mitkopplung der Transistoren T1 und T2 verantwortlich.

Aufgabe der vorliegenden Erfindung ist das Bereitstellen eines Komparators von hoher Empfindlichkeit, der bereits bei sehr geringen Signalhüben ausreichend regenerationsfähig ist, nur wenige Bauelemente benötigt und eine nicht allzu große Signallaufzeit aufweist.

Diese Aufgabe wird gelöst durch eine Halbleiterschaltung nach dem Patentanspruch.

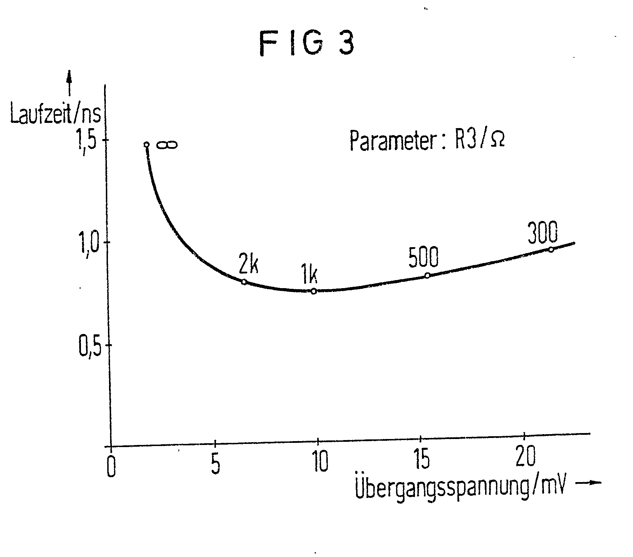

Die Erfindung wird im folgenden anhand der Figuren 2 und 3 näher erläutert.

Figur 2 zeigt eine erfindungsgemäße Schaltungsanordnung eines bipolaren Verstärkers.

Figur 3 zeigt in einem Diagramm den Zusammenhang zwischen der Signallaufzeit und der Empfindlichkeit in Abhängigkeit von einem erfindungsgemäßen Parameter.

Eine Schaltung nach Fig. 2 unterscheidet sich von einer nach Fig. 1 dadurch, daß zwischen die Emitter der Transistoren T3 und T4 der Widerstand R3 eingefügt ist, der eine Gegenkopplung bewirkt. Dabei tragen gleiche Elemente wie in Fig. 1 die gleichen Bezugszeichen.

Die Auswirkungen verschiedener Dimensionierungen des in Fig. 2 eingeführten Widerstands R3 auf die Signallaufzeit und die Empfindlichkeit gibt das in Fig. 3 dargestellte Diagramm wieder, in dem die Signallaufzeit in Abhängigkeit von der Übergangsspannung aufgetragen ist. Für R3 = $\infty$ (Fig. 1) ist die Signallaufzeit maximal, die Übergangsspannung minimal. Mit kleineren Werten für R3 ändern sich die beiden Variablen zunächst gegensinnig, bis für R3 = 1 kOhm das Laufzeitminimum von 0,75 ns bei einer Übergangsspannung von 10 mV erreicht wird. Mit noch kleineren Werten für R3 steigen dann sowohl die Laufzeit als auch die Übergangsspannungen an. Im optimalen Arbeitspunkt für R3 = 1 kOhm erreicht man gegenüber einem Gegentakt-Stromschalter-Komparator bei gleicher (50 Ohm —) Widerstandslast und gleichem Strom eine um den Faktor 3 größere Laufzeit bei gleichzeitiger Reduzierung der Eingangs-Übergangsspannung um den Faktor 5.

In hochintegrierten Schaltungen wirkt sich die größere Signallaufzeit wegen der an sich schon großen Bahnlaufzeiten nur geringfügig aus, die die Verlustleistung bestimmenden niedrigeren Signalhube bedeuten dagegen einen erheblichen Fortschritt auf dem Weg zu angestrebten noch höheren Integrationsdichten.

## Patentanspruch

Bipolare Halbleiterschaltungsanordnung mit Transistoren eines Leitungstyps mit einer aus zwei Transistoren (T1, T2) gebildeten Differenzverstärkerstufe, deren Kollektoren kreuzweise auf die Basen rückgekoppelt sind, deren Emitter mit dem einen Anschluß einer mit ihrem anderen Anschluß an ein Versorgungspotential geschalteten Stromquelle (S) verbunden sind, mit zwei Steuertransistoren (T3, T4), wobei der Kollektoranschluß jeweils eines Transistors der Differenzverstärkerstufe (T1, T2) mit dem Emitteranschluß jeweils eines Steuertransistors (T3, T4) verbunden ist, wobei der Kollektoranschluß jedes dieser beiden Steuertransistoren (T3, T4) über einen Widerstand (R1, R2) an ein weiteres Versorgungspotential geschaltet ist, wobei an den Basisanschlüssen dieser Steuertransistoren (T3, T4) komplementäre Eingangssignale liegen und an den Kollektoren der Steuertransistoren (T3, T4) komplementäre Ausgangssignale liegen, dadurch gekennzeichnet, daß die Emitter der Steuertransistoren (T3, T4) über einen Widerstand (R3) miteinander verbunden sind.

## Claim

Bipolar semiconductor circuit arrangement containing transistors of one conduction type having a differential amplifier stage formed from two transistors (T1, T2) whose collectors are fed back crosswise to the bases and whose emitters are connected to one terminal of a current source (S) whose other terminal is connected to a supply potential, and containing two control transistors (T3, T4), the collector terminal of in each case one transistor of the differential amplifier stage (T1, T2) being connected to the emitter teminal of in each case one control transistor (T3, T4), the collector terminal of each of these two control transistors (T3, T4) being connected via a resistor (R1, R2) to a further supply potential, complementary input signals being present at the base terminals of said control transistors (T3, T4) and complementary output signals being present at the collectors of the control transistors (T3, T4), characterized in that the emitters of the control transistors (T3, T4) are connected to one another via a resistor (R3).

## Revendication

Montage bipolaire à semi-conducteurs, comprenant des transistors d'un type de conduction, avec un étage amplificateur différentiel constitué de deux transistors (T1, T2) dont les collecteurs sont couplés en rétroaction et en croix avec les bases, dont les émetteurs sont reliés à une borne d'une source de courant (S) dont l'autre borne est connectée à un potentiel d'alimentation, ainsi que deux transistors de commande (T3, T4) la connexion de collecteur d'un transistor de l'étage amplificateur différentiel (T1, T2) étant reliée chaque fois à la connexion d'émetteur d'un transistor de commande (T3, T4), la connexion de collecteur de chacun des deux transistors de commande (T3, T4) étant reliée à travers une résistance (R1, R2) à un autre potentiel d'alimentation, avec application de signaux d'entrée complémentaires aux connexions de base des transistors de commande (T3, T4) et application de signaux de sortie complémentaires aux collecteurs des transistors de commande (T3, T4), caractérisé en ce que, les émetteurs des transistors de commande (T3, T4) sont reliés entre eux à travers une résistance (R3).

FIG 1

FIG 2

# F I G 3

Laufzeit/ns

Parameter : R3/Ω

1,5 ∞

1,0 300

2k 1k 500

0,5

0 5 10 15 20

Übergangsspannung/mV →